# EUROPÄISCHE PATENTSCHRIFT

(11) **EP 0 880 706 B1**
(45) Veröffentlichungstag und Bekanntmachung des Hinweises auf die Patenterteilung: **25.09.2002**
(21) Anmeldenummer: 97917220.2
(22) Anmeldetag: 12.02.1997
(51) Int. Cl.: G01R 1/073

(54) **ANORDNUNG ZUM TESTEN VON HALBLEITERSTRUKTUREN**
ARRANGEMENT FOR THE TESTING OF SEMICONDUCTOR STRUCTURES
MONTAGE POUR LE CONTROLE DE STRUCTURES A SEMICONDUCTEUR

(30) Priorität: 12.02.1996 DE 19604833
(43) Veröffentlichungstag der Anmeldung: 02.12.1998
(73) Patentinhaber: Karl Suss Dresden GmbH, 01561 Sacka (DE)
(72) Erfinder: WELSCH, Reinhard, D-01069 Dresden (DE); DIETRICH, Claus, D-01219 Dresden (DE); HÜLSMANN, Thomas, D-81373 München (DE); RUNGE, Dietmar, D-01454 Grosserkmannsdorf (DE)
(74) Vertreter: Adler, Peter, Dipl.-Ing.
(86) Internationale Anmeldenummer: DE9700260
(87) Internationale Veröffentlichungsnummer: WO97029380

(56) Entgegenhaltungen:
- JP-A- 7 014 898
- US-A- 3 996 517
- IBM TECHNICAL DISCLOSURE BULLETIN, Bd. 28, Nr. 12, Mai 1986, Seiten 5543-5549, XP002033517 "Test Module Assembly"
- PROCEEDINGS OF THE INSTRUMENTATION AND MEASUREMENT TECHNOLOGY CONFERENCE, ADVANCED TECHNOLOGIES IN I & M HAMAMATSU, MAY 10 - 12, 1994, Bd. 3, 10.Mai 1994, INSTITUTE OF ELECTRICAL AND ELECTRONICS ENGINEERS, Seiten 1492-1496, XP000502047 INUZUKA E ET AL: "EMISSION MICROSCOPY IN SEMICONDUCTOR FAILURE ANALYSIS"

## Beschreibung

Die Erfindung betrifft eine Anordnung zum Testen von Halbleiterstrukturen, die mit einem Chuck zur Aufnahme einer Halbleiterscheibe, welche eine im wesentlichen unstrukturierte Rückseite und eine Vorderseite mit der Struktur der zu testenden Chips aufweist, versehen ist. Zur Halterung von Kontaktiernadeln, die auf Kontaktinseln des zu testenden Chips auflegbar sind, ist diese Anordnung mit mehreren Nadelhaltern versehen. Der Chuck ist dabei mit Befestigungsmitteln für die Halbleiterscheibe versehen und zur Positionierung, mittels einer Positioniervorrichtung gesteuert, relativ zu den Kontaktiernadeln bewegbar.

Beispielsweise aus der US-Patentschrift 3,996,517, von der die Erfindung ausgeht, ist es bekannt, zum Testen von Halbleiterchips, die sich im Scheibenverband auf der Halbleiterscheibe befinden, auf Kontaktinseln dieser Chips Kontaktnadeln aufzulegen, die der Verbindung des Halbleiterchips mit einer äußeren Testanordnung dienen. Bei dem Testvorgang selbst werden die elektrischen Eigenschaften festgestellt, die der Chip aufweist. Während des Kontaktier-vorganges wird die Halbleiterscheibe mittels Vakuum gehalten.

In "IBM TECHNICAL DISCLOSURE BULLETIN; Bd. 28, Nr. 12, Mai 1986, Seiten 5543-5549" ist eine Anordnung zum Testen von Halbleiterscheiben beschrieben, die ein Kontaktieren der Halbleiterscheibe von oben und unten ermöglicht. Im Gegensatz zur US-Patentschrift 3,996,517 erfolgt hier das Halten der Halbleiterscheibe mittels mechanischer Klemmen, die an den Rand der Halbleiterscheibe angreifen. Im übrigen dient diese Testanordnung auch dem Testen des elektrischen Verhaltens der Halbleiterstrukturen.

In der US-PS 5,493,236 ist eine Testeinrichtung dargestellt, die zusätzlich zum Testen elektrischer Eigenschaften das OBIC (optical beam used carry) realisiert. Hierzu wird eine herkömmliche Testeinrichtung, wie sie auch in dem US-Patent 3,996,517 dargestellt ist, mit einem optischen Mikroskop ergänzt, das unter der Unterseite der Halbleiterscheibe angeordnet ist. Durch dieses Mikroskop wird die Halbleiterscheibe mit einem Laserstrahl beaufschlagt. Diese Beaufschlagung zeigt bei Defekten eine elektrische Reaktion, die an den Kontaktiernadeln gemessen wird.

Ein nahezu umgekehrtes Verfahren ist aus "Proceedings of the instrumentation and measurement technology conference, advanced technologies in I & M Hammatsu, May 10-12, 1994, Bd. 3, 10. Mai 1994, Institute of Electrical and Electronics Engineers, Seiten 1492-1496, Emission microscopy in semiconductor failure analysis" bekannt. Dabei wird zum Testen von Chips, die aus dem Scheibenverband vereinzelt sind und zu Bauelementen montiert oder vormontiert sind, nicht nur das elektrische Verhalten sondern auch das Strahlungsverhalten des Chips zu untersuchen. Dabei werden die von der Schaltungsstruktur des Chips während einer Beaufschlagung des Chips mit elektrischer Spannung erzeugten Photoemissionen, die zumeist im Infrarotbereich liegen, festgestellt. Anschließend können beispielsweise über einen Vergleich mit Strahlungsbildern exakt arbeitender Vergleichschips oder anhand unnormaler Strahlungserzeugungen Fehlfunktionen des zu prüfenden Chips festgestellt werden.

Zur Realisierung dieses Testverfahrens ist es bekannt, eine Infrarotbeobachtungseinrichtung einzusetzen, die auf die Vorderseite des Chips gerichtet ist. Während des Testlaufes nimmt diese Infrarotbeobachtungseinrichtung das Infrarot-Strahlungsbild des Chips auf. Sie ist in der Lage, extrem schwaches Licht, das insbesondere durch Fehlfunktionen eines Halbleiterchips erzeugt wird, darzustellen und zu analysieren. Somit können beispielsweise Stellen auf dem Chip erkannt werden, die infolge einer Fehlfunktion Wärmestrahlung erzeugen, die Fehlströme bei Oxiddurchbrüchen oder in Gateoxidschichten aufweisen oder nicht bestimmungsgemäße Emissionen in PN-Übergängen zeigen. Eine derartige Infrarotbeobachtungseinrichtung kann als Emissionsmikroskop oder als hochempfindliche CCD-Kamera ausgeführt sein.

Allerdings wird immer häufiger von der Möglichkeit Gebrauch gemacht, auf den Chips Metalleitbahnen, unter Umständen sogar in mehreren Lagen, anzuordnen. Zumeist sind diese Leitbahnen in den obersten Schichten des Chips also nahe an des Vorderseite angeordnet. Diese Leitbahnen absorbieren oder reflektieren die dargestellte Photoemission aber so stark, daß sie eine Beobachtung der extrem schwachen Lichtstrahlung durch eine Infrarotbeobachtungseinrichtung verhindern.

Zur Umgehung dieses Nachteiles ist es bekannt, die Beobachtung des Strahlungsverhaltens des montierten Chips von dessen Rückseite aus vorzunehmen. Nachteilig ist es dabei, daß bei Feststellung einer Fehlfunktion das montierte Chip verworfen werden muß. Damit ist der teilweise erhebliche Aufwand der Chipmontage ebenfalls nicht mehr nutzbar.

Es ist nunmehr Aufgabe der Erfindung, eine rechtzeitige und zuverlässige Fehlererkennung nicht oder nicht voll funktionstüchtiger Chips vor einer Vereinzelung zu ermöglichen, um unnötigen Aufwand bei der Vereinzelung und Montage von defekten Chips zu vermeiden.

Gemäß der Erfindung wird die Aufgabe dadurch gelöst, daß der Chuck einen die Rückseite der Halbleiterscheibe nach oben freigebenden Aufnahmebereich mit einer Aufnahmeebene für die Halbleiterscheibe aufweist, wobei die Aufnahmeebene oberhalb des Nadelträgers angeordnet ist, und die Kontaktiernadeln derart nach oben gerichtet sind, daß sie die Kontaktinseln der Halbleiterchips auf der nach unten gerichteten Vorderseite der Halbleiterscheibe kontaktieren.

In den Aufnahmebereich kann die Halbleiterscheibe nunmehr face-down eingesetzt werden. Da die Halbleiterscheibe in der Aufnahmeebene und damit über den Nadelträgern liegt und die Nadeln nach oben gerichtet sind, wird es möglich, die Halbleiterchips von unten zu kontaktieren. Der Aufnahmebereich gibt die Rückseite der Halbleiterscheibe nach oben hin frei, so daß die Rückseite von oben her beobachtet werden kann.

In einer zweckmäßigen Ausgestaltung der Erfindung ist vorgesehen, daß die Nadelhalter auf einer bezüglich der Bewegung der als x-y-Kreuztisch ausgebildeten Positionier vorichtung ortsfesten Grundplatte befestigt sind.

Zur Realisierung einer Relativbewegung zwischen Chuck und Kontaktiernadeln ist es möglich, entweder den Chuck oder die Kontaktiernadeln zu bewegen. Bei der ortsfesten Anordnung der Nadelhalter wird eine Bewegung des Chucks realisiert. Da der Chuck im allgemeinen das Bauteil mit der geringeren Masse ist, wird damit eine schnellere Positionierung der Kontaktnadeln erreicht.

Besonders günstig ist es, das Befestigungsmittel als mechanische Halterung und/oder als Vakuumhalterung auszuführen. Mit einer mechanischen Befestigung kann die Halbleiterscheibe eingespannt werden, was mit einfachen Mitteln realisiert werden kann. Mit einer Vakuumhalterung können dahingegen wesentlich größere Haltekräfte erzielt werden, ohne eine Beschädigung der Halbleiterscheibe zu provozieren. In der Praxis kann es dabei günstig sein, sowohl eine mechanische als auch eine Vakuumhalterung vorzusehen. Mit der mechanischen Halterung kann die Halbleiterscheibe solange festgehalten werden, bis die Vakuumhalterung wirkt.

In einer günstigen Ausführung bestehen die mechanischen Befestigungsmittel aus einem Gleitstück, das an den Rand der Halbleiterscheibe derart federbelastet angreift, daß die Federkraft den Rand der Halbleiterscheibe gegen gegenüberliegende Anschläge drückt. Beim Einsetzen einer Halbleiterscheibe kann das Gleitstück einfach entgegen seiner Federkraft gedrückt und anschließend die Halbleiterscheibe eingesetzt werden. Wird das Gleitstück losgelassen, tritt sofort ein Festklemmen der Halbleiterscheibe ein.

In einer anderen günstigen Ausgestaltung, die gegebenenfalls mit einer mechanischen Halterung kombiniert eingesetzt werden kann, ist als Vakuumhalterung eine Ansaugfläche vorgesehen, auf die die Vorderseite oder die Rückseite der Halbleiterscheibe auflegbar ist und die mit einer mit einer Vakuumquelle verbundenen Ansaugnut versehen ist. Bei Auflegen einer Halbleiterscheibe auf die Ansaugfläche wird die Ansaugnut verschlossen wodurch die Halbleiterscheibe bei Anlegen eines Vakuums angesaugt und damit festgehalten wird.

Weiterhin ist es zweckmäßig, daß der Chuck mit einem mit dem x-y-Kreuztisch verbindbaren und einen Abstand zwischen dem Chuck und dem Kreuztisch realisierenden Distanzstück versehen ist.

Durch dieses Distanzstück wird es möglich, zwischen dem Kreuztisch und dem Chuck Bauelemente, wie die Nadelträger, anzuordnen. Damit kann die herkömmliche Bauart von Probern im wesentlichen eingehalten werden. Eine andere Möglichkeit bestünde beispielsweise darin, die x-y-Bewegung von außen, z.B. von einem fernliegenden x-y-Antrieb einzuleiten.

Besonders günstig ist es, die Positioniereinrichtung unter dem Chuck anzuordnen. Damit können alle herkömmlichen Positionierverfahren weiterhin eingesetzt werden, mit dem einzigen Unterschied, daß sich die Beobachtungsrichtung der Positioniereinrichtung, die zumeist als Kamera ausgebildet ist, ändert, was allerdings kaum eine Einfluß auf das Positionierverfahren hat.

Zu Realisierung einer Abstandshalterung zwischen dem Chuck und dem Nadelhalter ist vorgesehen, daß der Chuck derart plattenförmig ausgeführt ist, daß er den Aufnahmebereich für eine Halbleiterscheibe und beidseitig des Aufnahmebereiches angeordnete äußere Laschen aufweist, an deren äußeren Enden die Distanzstücken im wesentlichen senkrecht zu den Laschen befestigt sind.

In einer bevorzugten Ausgestaltung der Erfindung weist der Aufnahmebereich einen Durchbruch mit einer zu der Fläche der Halbleiterscheibe zumindest näherungsweise kongruenten Durchbruchsfläche auf, wobei auf der den Kontaktnadeln zugewandten Seite des Chuck an dem Durchbruch eine die Durchbruchsfläche verringernde ringförmige Aufnahme vorgesehen ist. Diese Aufnahme ist auf der den Kontaktiernadeln abgewandten Seite als Ansaugfläche ausgeführt und mit einer Ringnut versehen, in die ein Vakuumkanal mündet.

Diese Aufnahme berührt zweckmäßigerweise nur den Rand der Halbleiterscheibe. Damit bleibt der übrige Teil der Halbleiterscheibe zur Kontaktierung beziehungsweise zur Beobachtung frei.

Günstig ist es, die Vakuumhalterung so auszuführen, daß der Vakuumkanal durch die äußeren Laschen und das Distanzstück geführt ist, daß eine Aufnahme für ein Distanzstück vorgesehen ist, in die das Distanzstück einsetzbar ist und in der ein mit dem Vakuumkanal des Distanzstückes verbindbarer Vakuumanschluß angeordnet ist.

Damit kann erreicht werden, daß der Chuck nach einer Bestükkung mit einer Halbleiterscheibe aufgesetzt werden kann und gleichzeitig eine Versorgung mit Vakuum erfolgt.

Eine Variante der Erfindung ist so gestaltet, daß die Grundplatte Aufnahmemittel für die direkte Aufnahme der Nadelhalter und Aufnahmemittel für die Aufnahme einer zusätzlichen Oberplatte aufweist, die mit Distanzstücken an der Grundplatte befestigbar ist und auf der zusätzliche Nadelhalter befestigbar sind, wobei deren Kontaktiernadeln nach unten gerichtet einsetzbar sind.

Die Erfindung soll nachfolgend anhand eines Ausführungsbeispieles näher erläutert werden. In den zugehörigen Zeichnungen zeigt
- Fig. 1: eine erfindungsgemäße Anordnung in Vorderansicht und Draufsicht für ein Testen einer Halbleiterscheibe mittels von unten angreifenden Kontaktiernadeln,

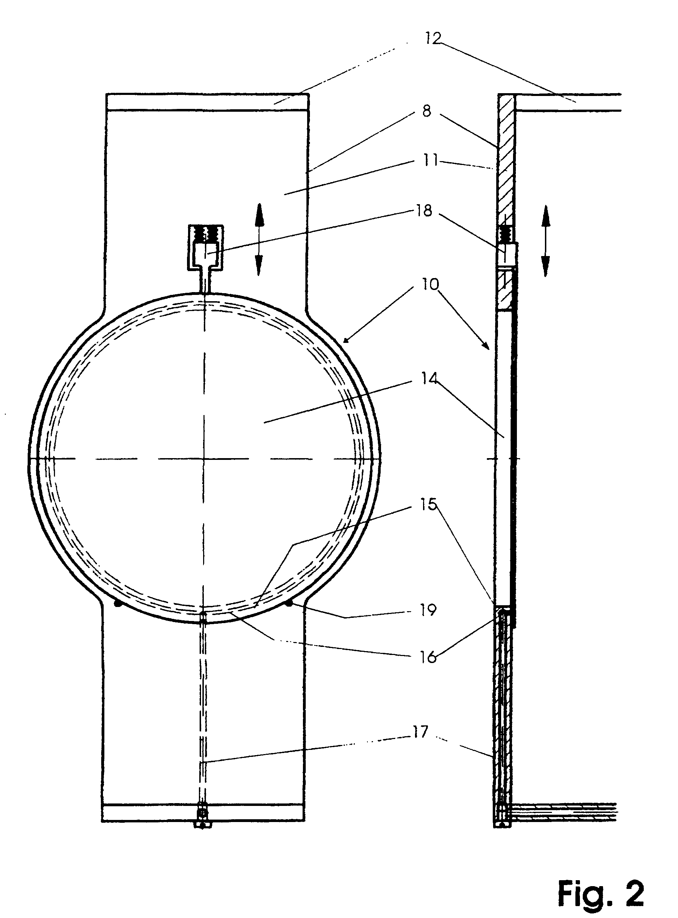

- Fig. 2: eine Draufsicht und einen Längsschnitt eines Chuck einer erfindungsgemäßen Testervorrichtung,
- Fig. 3: ist entfallen,
- Fig. 4: eine Vorderansicht und Draufsicht einer erfindungsgemäßen Anordnung zum Testen einer Halbleisterscheibe mittels einer von unten angreifenden Testerkarte,
- Fig. 5: eine Vorderansicht und Draufsicht einer erfindungsgemäßen Anordnung zum Testen einer Halbleiterscheibe mittels von unten und von oben angreifenden Kontaktiernadeln und
- Fig. 6: eine Vorderansicht und Draufsicht einer erfindungsgemäßen Anordnung zum Testen einer Halbleiterscheibe mittels von unten und oben angreifenden Kontaktiernadeln und einer von unten angreifenden Testerkarte.

Anordnungen zum Testen von Halbleiterscheiben, wie sie in den Zeichnungen dargestellt sind, weisen einen Grundrahmen 1 auf. Mit diesem Grundrahmen 1 ist eine Grundplatte 2 über Entkopplungsglieder 3 verbunden. Eine Oberplatte 4 stützt sich über Abstandshalter 5 auf der Grundplatte 2 ab.

Mit dem Grundrahmen 1 verbunden ist eine Positioniervorrichtung 6, die in waagerecht liegender x- und waagerecht liegender y-Richtung verschiebbar ist. Die Positioniervorrichtung 6 weist eine Bühne 7 auf, auf die der Chuck 8 auflegbar ist. Der Chuck 8 dient der Aufnahme einer Halbleiterscheibe 9. Hierfür ist ein Aufnahmebereich 10 in der Oberseite des Chuck vorgesehen. Da dieser Aufnahmebereich 10 in der Nähe der Oberplatte 4, das heißt über der Grundplatte 2 liegt, umgreift der Chuck 8 die Grundplatte 2 weiträumig, so daß eine Übertragung der Bewegung der Positioniervorrichtung 6 auf den Chuck 8 möglich ist. Hierfür sind Laschen 11 vorgesehen, die sich beidseitig des Aufnahmebereiches des Chuck befinden. Senkrecht zu den Laschen 11 sind an den äußeren Enden Distanzstücken 12 befestigt, die den Abstand zwischen der Bühne 7 und der Aufnahmeebene 13 der Halbleiterscheibe 9 einstellen.

Der Chuck 8 ist auf seiner Oberseite plattenförmig ausgebildet, wobei diese Fläche zumindest parallel zur Aufnahmeebene 13 der Halbleiterscheibe 9 liegt. In dem Aufnahmebereich 10 ist der Chuck 8 mit einem Durchbruch 14 versehen. Die Fläche dieses Durchbruches ist zur Fläche der Halbleiterscheibe 9 annähernd kongruent, so daß die Halbleiterscheibe 9 in den Durchbruch 14 eingelegt werden kann. Zur Fixierung der Halbleiterscheibe 9 ist der Durchbruch 14 mit einer ringförmigen Aufnahme 15 versehen. In dieser ringförmigen Aufnahme 15 ist eine Ringnut 16 eingebracht, die durch die Halbleiterscheibe 9 verschließbar ist. In diese Ringnut 16 mündet ein Vakuumkanal 17, der durch eine Lasche 11 und weiterhin durch das Distanzstück 12 geführt ist und am Ende des Distanzstückes 12 austritt, so daß er dort mit einer Vakuumöffnung in der Bühne 7 verbindbar ist. Damit kann eine Vakuumansaugung für die Halbleiterscheibe 9 in dem Aufnahmebereich 10 realisiert werden. Zur einstweiligen Fixierung der Halbleiterscheibe vor Aufbau eines Vakuums ist ein mechanisches Befestigungsmittel vorgesehen. Dieses besteht aus einem Gleitstück 18, welches in radialer Richtung zu dem Durchbruch 14 und parallel zur Aufnahmeebene 13 bewegbar ist und welches an den Rand der Halbleiterscheibe 9 federbelastet angreift. Damit wird die Halbleiterscheibe 9 gegen zwei Stifte 19 gedrückt und somit mechanisch fixiert. Dies hat den Vorteil, daß die Halbleiterscheibe 9 in den Durchbruch 14 außerhalb der Anordnung eingelegt werden kann und bereits damit mechanisch fixiert ist. Mit Aufsetzen des Chuck 8 auf die Bühne 7 wird sodann die Ringnut 16 mit Vakuum beaufschlagt, wodurch die Halbleiterscheibe 9 angesaugt und festgehalten wird.

Durch diese Vakuumansaugung wird die Halbleiterscheibe einerseits lagefixiert und andererseits können damit Kontaktierkräfte aufgenommen werden, wenn auf der Seite die Halbleiterscheibe 9 kontaktiert wird, auf der sie auch gehalten ist.

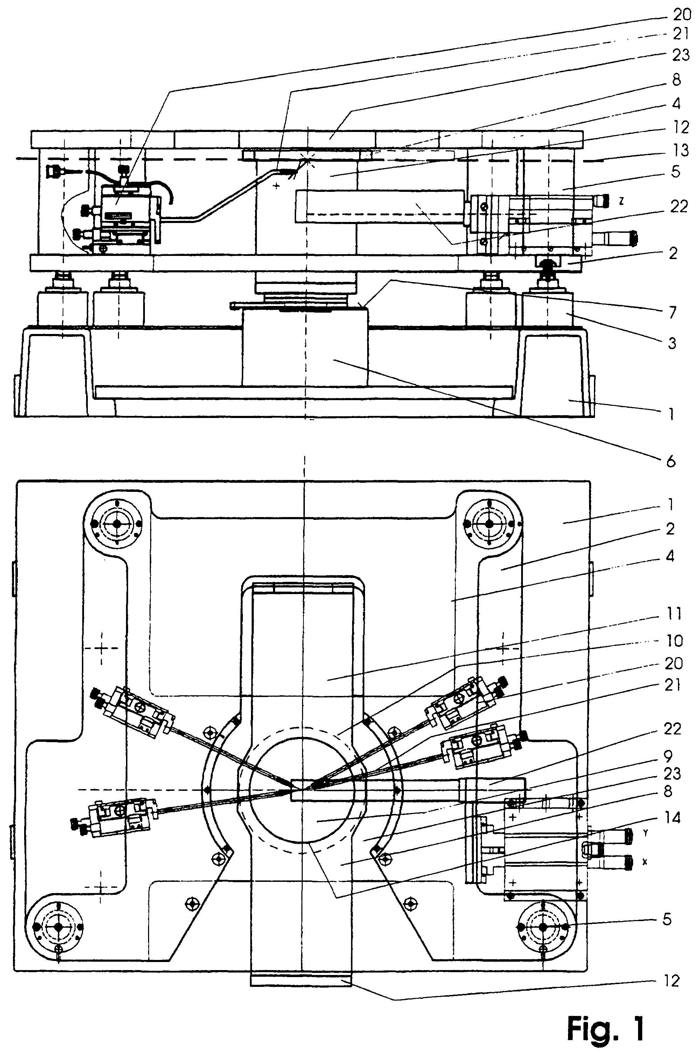

Wie in Fig. 1 dargestellt, dient die Grundplatte 2 der Aufnahme von Nadelhaltern 20, die die Kontaktiernadel 21 tragen. Werden nunmehr in Nadelhalter 20 nach oben gerichtete Kontaktiernadeln 21 eingesetzt, so können die Kontaktiernadeln durch den Durchbruch 14 an die Kontaktierinseln auf der Halbleiterscheibe 9 angreifen und die Testung kann beginnen. Zur Positionierung der relativen Stellung zwischen der Halbleiterscheibe 9 und den Kontaktiernadeln 21 ist ein Beobachtungsmikroskop 22 zwischen der Grundplatte 2 und der Oberplatte 4 angeordnet.

Die Oberplatte 4 weist in dem Bereich über dem Aufnahmebereich 10 des Chuck eine Beobachtungsöffnung 23 auf. Damit wird es möglich, in nicht näher dargestellter Weise von oben her durch diese Beobachtungsöffnung 23 und durch den Durchbruch 14 hindurch die obenliegende Rückseite der Halbleiterscheibe 9 zu beobachten, während auf der Vorderseite der Halbleiterscheibe 9 die Kontaktiernadeln 21 angreifen.

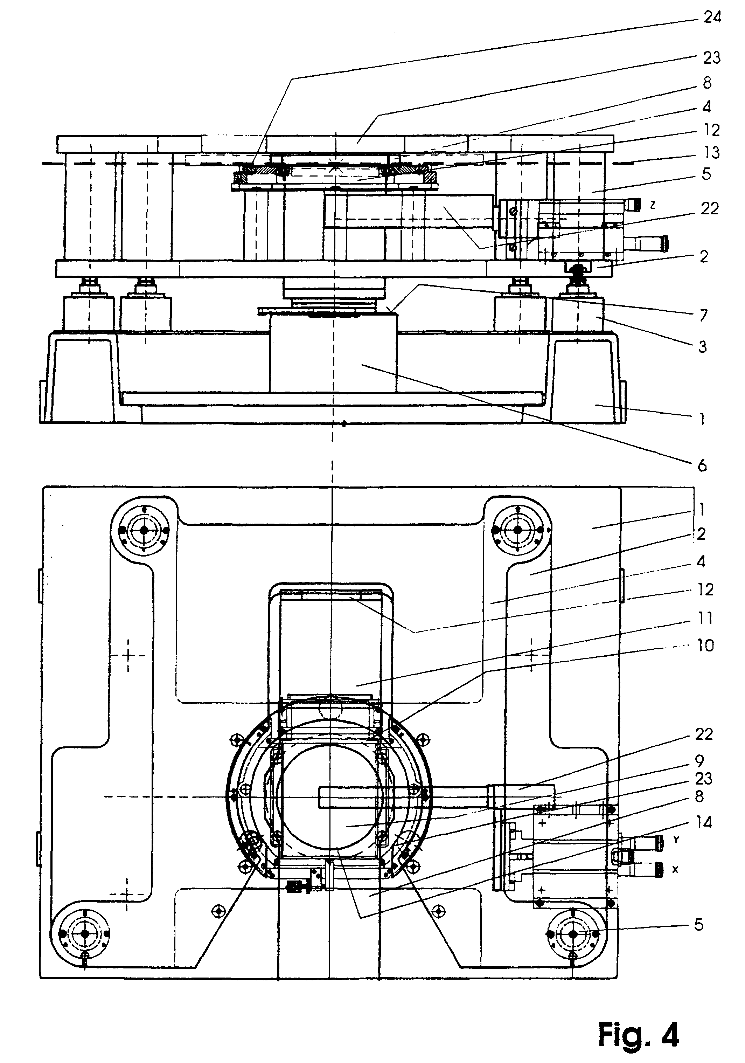

In Fig. 4 ist eine Möglichkeit des Einsatzes einer Testerkarte gezeigt. Auf einer Testerkarte sind die Kontaktiernadeln 21 befestigt. Über einem Adapter 24 ist die Testerkarte auf der Grundplatte 2 festgelegt. Somit greifen die nicht näher dargestellten Kontaktiernadeln der Testerkarte auf der untenliegenden Vorderseite der Halbleiterscheibe 9 an, wobei die Rückseite der Halbleiterscheibe 9 von oben beobachtet werden kann.

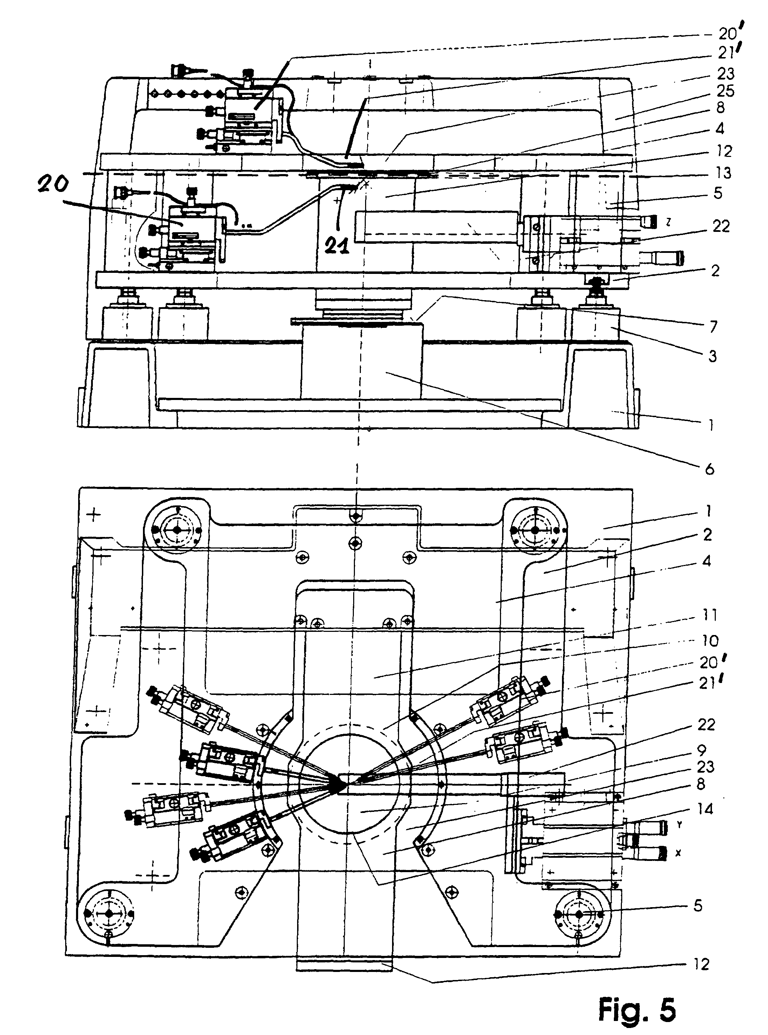

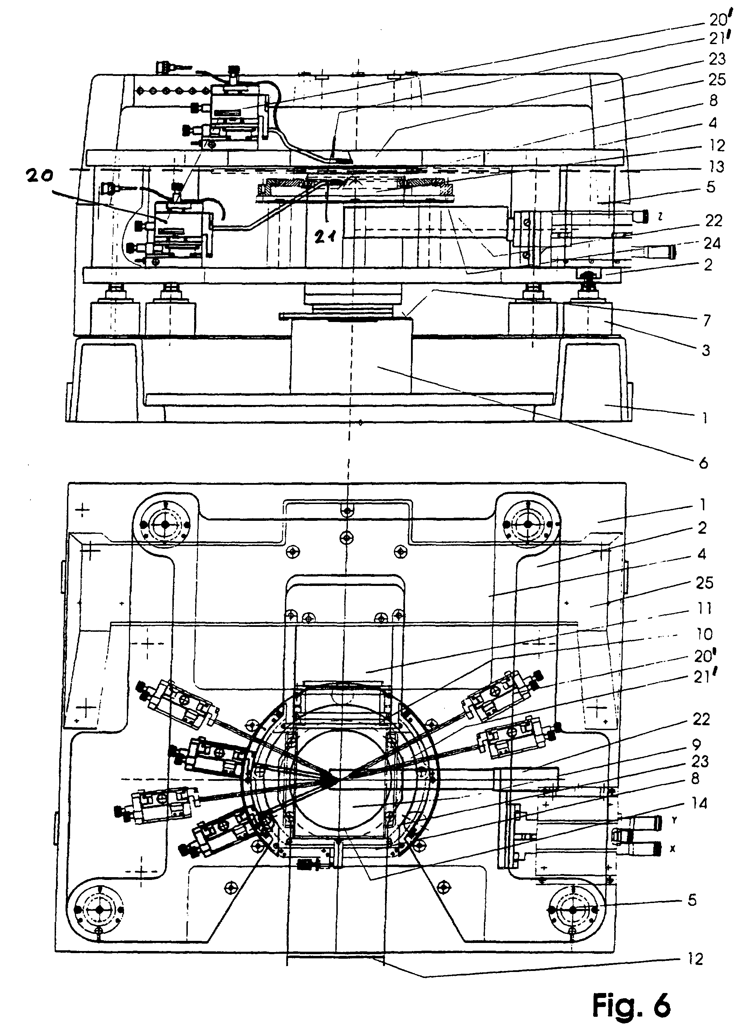

In Fig. 5 ist eine kombinierte Möglichkeit einer gleichzeitigen Vorder- und Rückseitenkontaktierung mittels in Nadelhaltern 20 und 20' gehaltenen Kontakiernadeln 21 und 21' dargestellt. In Fig. 6 ist eine gleichzeitige Vorder- und Rückseitenkontaktierung mittels Kontaktiernadeln und ein gleichzeitiger Einsatz einer Testerkarte dargestellt. In den Fig. 5 und 6 ist eine Mikroskopbrücke 25 über der Oberplatte 4 dargestellt, auf der das nicht näher dargestellte Beobachtungsmikroskop befestigt werden kann.

### Bezugszeichenliste

- 1: Grundrahmen
- 2: Grundplatte
- 3: Entkopplungsglied
- 4: Oberplatte
- 5: Abstandshalter
- 6: Positioniervorrichtung
- 7: Bühne
- 8: Chuck
- 9: Halbleiterscheibe
- 10: Aufnanmebereich
- 11: Lasche
- 12: Distanzstück
- 13: Aufnahmeebene
- 14: Durchbruch
- 15: ringförmige Aufnahme
- 16: Ringnut
- 17: Vakuumkanal
- 18: Gleitstück
- 19: Stift
- 20,20': Nadelhalter
- 21,21': Kontaktiernadel
- 22: Beobachtungsmikroskop
- 23: Beobachtungsöffnung
- 24: Adapter
- 25: Mikroskopbrücke

## Patentansprüche

1. Anordnung zum Testen von Halbleiterstrukturen, die mit einem Chuck (8) zur Aufnahme einer Halbleiterscheibe (9), welche eine im wesentlichen unstrukturierte Rückseite und eine Vorderseite mit der Struktur der zu testenden Chips aufweist, versehen ist und die zur Halterung von Kontaktiernadeln (21), die auf Kontaktinseln des zu testenden Chips auflegbar sind, mit mehreren Nadelhaltern (20) versehen ist, wobei der Chuck (8) mit Befestigungsmitteln für die Halbleiterscheibe (9) versehen ist und zur Positionierung, mittels einer Positioniervorrichtung gesteuert, relativ zu den Kontaktiernadeln (21) bewegbar ist , **dadurch gekennzeichnet, daß** der Chuck (8) einen die Rückseite der Halbleiterscheibe (9) nach oben freigebenden Aufnahmebereich (10) mit einer Aufnahmeebene (13) für die Halbleiterscheibe (9) aufweist, wobei die Aufnahmeebene (13) oberhalb des Nadelträgers (20) angeordnet ist, und die Kontaktiernadeln (21) derart nach oben gerichtet sind, daß sie die Kontaktinseln der Halbleiterchips auf der nach unten gerichteten Vorderseite der Halbleiterscheibe (9) kontaktieren.

2. Anordnung zum Testen von Halbleiterstrukturen nach Anspruch 1, **dadurch gekennzeichnet, daß** die Nadelhalter (20) auf einer bezüglich der Bewegung der als x-y-Kreuztisch (6) ausgebildeten Positioniervorrichtung ortsfesten Grundplatte (2) befestigt sind.

3. Anordnung zum Testen von Halbleiterstrukturen nach Anspruch 1 oder 2, **dadurch gekennzeichnet, daß** das Befestigungsmittel als mechanische Halterung und/oder als Vakuumhalterung ausgeführt ist.

4. Anordnung zum Testen von Halbleiterstrukturen nach Anspruch 3, **dadurch gekennzeichnet, daß** die mechanischen Befestigungsmittel aus einem Gleitstück (18) bestehen, das an den Rand der Halbleiterscheibe (9) derart federbelastet angreift, daß die Federkraft den Rand der Halbleiterscheibe (9) gegen gegenüberliegende Anschläge (19) drückt.

5. Anordnung zum Testen von Halbleiterstrukturen nach Anspruch 3, **dadurch gekennzeichnet, daß** als Vakuumhalterung eine Ansaugfläche (15) vorgesehen ist, auf die die Vorderseite oder die Rückseite der Halbleiterscheibe (9) auflegbar ist und die mit einer mit einer Vakuumquelle verbundenen Ansaugnut (16) versehen ist.

6. Anordnung zum Testen von Halbleiterstrukturen nach einem der Ansprüche 2 bis 5, **dadurch gekennzeichnet, daß** der Chuck (8) mit einem mit dem x-y-Kreuztisch (6) verbindbaren und einen Abstand zwischen dem Chuck (8) und dem Kreuztisch (6) realisierenden Distanzstück (12) versehen ist.

7. Anordnung zum Testen von Halbleiterstrukturen nach einem der Ansprüche 1 bis 6, **dadurch gekennzeichnet, daß** die Positioniereinrichtung (6) unter dem Chuck (8) angeordnet ist.

8. Anordnung zum Testen von Halbleiterstrukturen nach einem der Ansprüche 1 bis 7, **dadurch gekennzeichnet, daß** der Chuck (8) derart plattenförmig ausgeführt ist, daß er den Aufnahmebereich (10) für eine Halbleiterscheibe (9) und beidseitig des Aufnahmebereiches (10) angeordnete äußere Laschen (11) aufweist, an deren äußeren Enden die Distanzstücken (12) im wesentlichen senkrecht zu den Laschen (11) befestigt sind.

9. Anordnung zum Testen von Halbleiterstrukturen nach einem der Ansprüche 1 bis 8, **dadurch gekennzeichnet, daß** der Aufnahmebereich (10) einen Durchbruch (14) mit einer zu der Fläche der Halbleiterscheibe (9) zumindest näherungsweise kongruenten Durchbruchsfläche aufweist, wobei auf der den Kontaktnadeln (21) zugewandten Seite des Chuck (8) an dem Durchbruch eine die Durchbruchsfläche verringernde ringförmige Aufnahme (15) vorgesehen ist, daß diese Aufnahme (15) auf der den Kontaktiernadeln (21) abgewandten Seite als Ansaugfläche ausgeführt und mit einer Ringnut (16) versehen ist, in die ein Vakuumkanal (17) mündet.

10. Anordnung zum Testen von Halbleiterstrukturen nach Anspruch 8 und 9, **dadurch gekennzeichnet, daß** der Vakuumkanal (17) durch die äußeren Laschen (11) und das Distanzstück (12) geführt ist, daß eine Aufnahme für ein Distanzstück (12) vorgesehen ist, in die das Distanzstück (12) einsetzbar ist und in der ein mit dem Vakuumkanal (17) des Distanzstückes (12) verbindbarer Vakuumanschluß angeordnet ist.

11. Anordnung zum Testen von Halbleiterstrukturen nach einem der Ansprüche 2 bis 9, **dadurch gekennzeichnet, daß** die Grundplatte (2) Aufnahmemittel für die direkte Aufnahme der Nadelhalter (20) und Aufnahmemittel für die Aufnahme einer zusätzlichen Oberplatte (4) aufweist, die mit Distanzstükken (5) an der Grundplatte (2) befestigbar ist und auf der zusätzliche Nadelhalter (20') befestigbar sind, wobei deren Kontaktnadeln (21') nach unten gerichtet einsetzbar sind.

## Claims

1. Arrangement for the testing of semiconductor structures, which is provided with a chuck (8) for receiving a semiconductor wafer (9), which has a substantially unstructured rear side and a front side with the structure of the chips to be tested, and which is provided with a plurality of needle holders (20) for holding contacting needles (21) which can be placed on contact pads of the chip to be tested, the chuck (8) being provided with fastening means for the semiconductor wafer (9) and being movable for the positioning, controlled by means of a positioning device, in relation to the contacting needles (21), **characterized in that** the chuck (8) has a receiving region (10), which has a receiving plane (13) for the semiconductor wafer (9) and upwardly exposes the rear side of the semiconductor wafer (9), the receiving plane (13) being arranged above the needle carrier (20), and the contacting needles (21) being directed upwards in such a way that they contact the contact pads of the semiconductor chips on the downwardly directed front side of the semiconductor wafer (9).

2. Arrangement for the testing of semiconductor structures according to Claim 1, **characterized in that** the needle holders (20) are fastened on a base plate (2) that is fixed in place with respect to the movement of the positioning device designed as an x-y compound table (6).

3. Arrangement for the testing of semiconductor structures according to Claim 1 or 2, **characterized in that** the fastening means are configured as a mechanical holder and/or a vacuum holder.

4. Arrangement for the testing of semiconductor structures according to Claim 3, **characterized in that** the mechanical fastening means comprise a sliding piece (18), which acts in a spring-loaded manner on the edge of the semiconductor wafer (9) in such a way that the spring force presses the edge of the semiconductor wafer (9) against stops (19) lying opposite.

5. Arrangement for the testing of semiconductor structures according to Claim 3, **characterized in that** a suction surface (15), onto which the front side or the rear side of the semiconductor wafer (9) can be placed and which is provided with a suction groove (16) connected to a vacuum source, is provided as the vacuum holder.

6. Arrangement for the testing of semiconductor structures according to one of Claims 2 to 5, **characterized in that** the chuck (8) is provided with a spacing piece (12), which can be connected to the x-y compound table (6) and establishes a distance between the chuck (8) and the compound table (6).

7. Arrangement for the testing of semiconductor structures according to one of Claims 1 to 6, **characterized in that** the positioning device (6) is arranged under the chuck (8).

8. Arrangement for the testing of semiconductor structures according to one of Claims 1 to 7, **characterized in that** the chuck (8) is configured in the form of a plate, **in that** it has the receiving region (10) for a semiconductor wafer (9) and outer lugs (11), which are arranged on both sides of the receiving region (10) and at the outer ends of which the spacing pieces (12) are fastened substantially perpendicular to the lugs (11).

9. Arrangement for the testing of semiconductor structures according to one of Claims 1 to 8, **characterized in that** the receiving region (10) has an aperture (14) with an aperture surface that is at least approximately congruent with the surface of the semiconductor wafer (9), an annular receptacle (15), which reduces the aperture surface, being provided on the aperture on the side of the chuck (8) facing the contacting needles (21), **in that** this receptacle (15) is configured on the side facing away from the contacting needles (21) as a suction surface and is provided with an annular groove (16), into which a vacuum channel (17) opens.

10. Arrangement for the testing of semiconductor structures according to Claims 8 and 9, **characterized in that** the vacuum channel (17) is led through the outer lugs (11) and the spacing piece (12), **in that** a receptacle for a spacing piece (12) is provided, into which the spacing piece (12) can be inserted and in which a vacuum connection which can be connected to the vacuum channel (17) of the spacing piece (12) is arranged.

11. Arrangement for the testing of semiconductor structures according to one of Claims 2 to 9, **characterized in that** the base plate (2) has receiving means for directly receiving the needle holders (20) and receiving means for receiving an additional upper plate (4), which can be fastened to spacing pieces (5) on the base plate (2) and on which additional needle holders (20') can be fastened, the contacting needles (21') of which can be inserted in a downwardly directed manner.

## Revendications

1. Montage pour contrôler des structures semi-conductrices comprenant un mandrin (8) pour recevoir une plaquette semi-conductrice (9) ayant une face arrière essentiellement non structurée et une face avant avec la structure des puces à contrôler, et qui, pour tenir les aiguilles de contact (21) venant s'appliquer contre des îlots de contact des puces à contrôler, comporte plusieurs supports d'aiguilles (20),
le mandrin (8) comportant des moyens de fixation pour la plaquette semi-conductrice (9), et pouvant être déplacé par un dispositif de positionnement commandé par rapport aux aiguilles de contact (21),
**caractérisé en ce que**
le mandrin (8) comporte une zone de réception (10) libérant vers le haut le côté arrière de la plaquette semi-conductrice (9), avec un plan de réception (13) pour la plaquette semi-conductrice (9),
le plan de réception (13) se trouvant au-dessus du support d'aiguilles (20), et
les aiguilles de contact (21) sont dirigées vers le haut pour toucher les îlots de contact des puces semi-conductrices sur le côté avant de la plaquette semi-conductrice (9), côté avant tourné vers le bas.

2. Montage pour contrôler des structures semi-conductrices selon la revendication 1,
**caractérisé en ce que**
les supports d'aiguilles (20) sont fixés sur un dispositif de positionnement d'une plaque de base (2), fixe, comme plateau mobile en x et y (6).

3. Montage pour contrôler des structures semi-conductrices selon l'une quelconque des revendications 1 ou 2,
**caractérisé en ce que**
le moyen de fixation est un moyen de fixation mécanique et/ou un moyen de fixation par le vide.

4. Montage pour contrôler des structures semi-conductrices selon la revendication 3,
**caractérisé en ce que**
les moyens de fixation mécaniques se composent d'une pièce coulissante (18) appliquée par un ressort contre le bord de la plaquette semi-conductrice (9) pour que la force du ressort pousse le bord de la plaquette semi-conductrice (9) contre des butées opposées (19).

5. Montage pour contrôler des structures semi-conductrices selon la revendication 3,
**caractérisé en ce que**
le moyen de fixation par le vide comporte une surface aspirante (15) qui s'applique contre la face avant ou la face arrière de la plaquette semi-conductrice (9) et est munie d'une rainure d'aspiration (16) reliée à une source de vide.

6. Montage pour contrôler des structures semi-conductrices selon l'une quelconque des revendications 2 à 5,
**caractérisé en ce que**
le mandrin (8) est muni d'une pièce d'écartement (12) susceptible d'être reliée au plateau mobile en x, y (6) et assurant la distance entre le mandrin (8) et le plateau (6).

7. Montage pour contrôler des structures semi-conductrices selon l'une quelconque des revendications 1 à 6,
**caractérisé en ce que**
le dispositif de positionnement (6) se trouve sous le mandrin (8).

8. Montage pour contrôler des structures semi-conductrices selon l'une quelconque des revendications 1 à 7,
**caractérisé en ce que**
le mandrin (8) est en forme de plateau, il comporte une zone de réception (10) pour une plaquette semi-conductrice (9) et de part et d'autre de la zone de réception (10) il comporte des pattes extérieures (11) par lesquelles sont fixées les extrémités extérieures des pièces d'écartement (12) essentiellement de manière perpendiculaire aux pattes (11).

9. Montage pour contrôler des structures semi-conductrices selon l'une quelconque des revendications 1 à 8,
**caractérisé en ce que**
la zone de réception (10) comporte un passage (14) avec une surface de passage sensiblement congruente avec la surface de la plaquette semi-conductrice (9), sur le côté du mandrin (8) tourné vers les aiguilles de contact (21), le passage comporte un logement annulaire (15) réduisant la surface de passage, ce logement (15) étant réalisé comme surface aspirante sur le côté opposé à celui des aiguilles de contact (21) et comportant une rainure annulaire (16) reliée à un canal de vide (17).

10. Montage pour contrôler des structures semi-conductrices selon l'une quelconque des revendications 8 et 9,
**caractérisé en ce que**
le canal de vide (17) traverse les pattes extérieures (11) et la pièce d'écartement (12), et
un logement est prévu pour pouvoir insérer une pièce d'écartement (12) et comporte un branchement de vide qui peut être relié au canal de vide (17) de la pièce d'écartement (12).

11. Montage pour contrôler des structures semi-conductrices selon l'une quelconque des revendications 2 à 9,
**caractérisé en ce que**
la plaque de base (2) comporte des moyens de réception pour recevoir directement un support d'aiguilles (20) et des moyens de réception pour recevoir une plaque supérieure (4) supplémentaire fixée par des pièces d'écartement (5) à la plaque de base (2) et sur laquelle peuvent se fixer des supports d'aiguilles (20') supplémentaires dont les aiguilles de contact (21') sont dirigées vers le bas.
